# EUROPÄISCHE PATENTSCHRIFT

(11) **EP 3 260 733 B1**
(45) Veröffentlichungstag und Bekanntmachung des Hinweises auf die Patenterteilung: **07.08.2019**
(21) Anmeldenummer: 16175910.5
(22) Anmeldetag: 23.06.2016
(51) Int. Cl.: F16F 15/027

(54) **AKTIVES STATIONÄRES SCHWINGUNGSISOLATIONSSYSTEM**
ACTIV STATIONARY VIBRATION ISOLATING SYSTEM
SYSTEME D'ISOLATION D'OSCILLATIONS STATIONNAIRE ACTIF

(43) Veröffentlichungstag der Anmeldung: 27.12.2017
(73) Patentinhaber: Integrated Dynamics Engineering GmbH, 65479 Raunheim (DE)
(72) Erfinder: Evers, Arndt, 65375 Oestrich-Winkel (DE); Scharf, Till, 63150 Heusenstamm (DE)
(74) Vertreter: Blumbach · Zinngrebe Patentanwälte PartG mbB

(56) Entgegenhaltungen:
- DE-C1- 4 324 595
- JP-A- 2000 220 690
- US-A1- 2001 040 324
- US-A1- 2009 283 942

## Beschreibung

### Gebiet der Erfindung

Die Erfindung betrifft ein stationäres Schwingungsisolationssystem mit einem Isolator. Insbesondere betrifft die Erfindung einen als pneumatische Feder ausgebildeten Isolator mit einem Aktor zur aktiven Schwingungsisolation.

Die Erfindung betrifft insbesondere stationäre, also ortsfest, angeordnete Schwingungsisolationssysteme, auf welchen Lithographie- und/oder Metrologieanlagen zur Prozessierung von Halbleiterbauelementen schwingungsisoliert gelagert sind.

### Hintergrund der Erfindung

Stationäre Schwingungsisolationssysteme, wie sie insbesondere zur Aufnahme von Lithographie- oder Metrologiegeräten zur Prozessierung von Halbleitern verwendet werden, bestehen zumeist aus einem Tisch, welcher auf mehreren Isolatoren gelagert ist.

Aus der Praxis bekannt sind insbesondere aktive Schwingungsisolationssysteme, bei denen eine aktive Regelung vorhanden ist, die seismischen Schwingungen oder von der zu isolierenden Last (Maschinen) verursachten Schwingungen entgegenwirkt. So können über am Boden und/oder an der zu isolierenden Last angeordnete Sensoren Schwingungen gemessen werden. Die gewonnenen Messwerte werden von einer Regeleinrichtung dazu verwendet, aktiv Kompensationssignale zu erzeugen, über die Aktoren zur aktiven Schwingungsisolation angesteuert werden. In der Praxis werden zumeist in oder an einem pneumatischen oder mechanischen (z.B. Schraubenfeder) Isolator angeordnete Magnetaktoren verwendet, um Gegenkräfte zu erzeugen.

Mit der Größe der zu prozessierenden Halbleiterbauelemente steigt auch die Größe der hierfür verwendeten Anlagen. Hierdurch sind durch die Aktoren aufzubringende Reaktionskräfte immer höher, was die Verwendung von elektrisch angetriebenen Aktoren erschwert. Dies führt dazu, dass in einer Wirkrichtung mehrere, nach dem magnetischen Prinzip arbeitende Aktoren parallel geschaltet werden müssen. Dies ist aufwendig und aufgrund des knappen Bauraums im manchen Anwendungsfällen auch nicht möglich. Die Verwendung von Magnetaktoren wird des Weiteren durch deren immer vorhandene Wärmeabfuhr begrenzt.

Die Notwendigkeit der Ansteuerung von Magnetaktoren kann zwar durch die Einbindung einer pneumatischen Niveauregulierung des Schwingungsisolationssystems in die aktive Schwingungsisolation reduziert werden. Dies genügt jedoch nicht immer, um vorstehend genannte Nachteile zu beseitigen.

Ein mechanischer Schwingungsisolator mit einer Schraubenfeder ist in der Offenlegungsschrift EP 2 759 763 A2 (Integrated Dynamics Engineering GmbH) gezeigt Die Offenlegungsschrift EP 2 998 611 A2 (Integrated Dynamics Engineering GmbH) zeigt einen Isolator mit einer Luftfeder, dessen Charakteristik über ein austauschbares Blattfederpaket anpassbar ist und welcher ein Biegependel aufweist, um eine Isolationswirkung in horizontaler Richtung bereitzustellen.

Die Offenlegungsschrift US 2001/0040324 A1 zeigt ein Isolator, der einen in horizontaler Richtung wirksamen pneumatischen Aktor und einen in vertikaler Richtung wirksamen pneumatischen Aktor umfasst.

### Aufgabe der Erfindung

Der Erfindung liegt demgegenüber die Aufgabe zugrunde, die genannten Nachteile des Standes der Technik zur reduzieren. Insbesondere soll ein flexibel einsetzbarer Isolator für ein aktives Schwingungsisolationssystem bereitgestellt werden, mit welchem sich hohe Kompensationskräfte bei gleichzeitig geringer Wärmeabfuhr erreichen lassen.

### Zusammenfassung der Erfindung

Die Aufgabe der Erfindung wird durch ein aktives stationäres Schwingungsisolationssystem nach Anspruch 1 gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft ein stationäres Schwingungsisolationssystem mit einem Isolator. Insbesondere betrifft die Erfindung ein Schwingungsisolationssystem, auf welchem Maschinen zur Prozessierung von Halbleiterbauelementen, insbesondere Lithographie- oder Metrologiegeräte, schwingungsisoliert gelagert sind.

Ein derartiges Schwingungsisolationssystem umfasst in der Regel eine Platte, welche über zumindest drei Isolatoren schwingungsisoliert gegenüber dem Boden angeordnet ist.

Der Isolator ist in horizontaler und vertikaler Richtung wirksam, d.h. eine Entkopplung gegenüber dem Boden ist sowohl in horizontaler als auch in vertikaler Richtung vorgesehen.

Weiter umfasst der Isolator hierzu eine Feder, die zumindest in vertikaler Richtung wirksam ist

Die Feder ist gemäß der Erfindung als pneumatische Feder ausgebildet.

Bei einer Ausführungsform der Erfindung ist die pneumatische Feder nur in vertikaler Richtung wirksam, wohingegen für eine Entkopplung in horizontaler Richtung ein anderes Bauelement, insbesondere ein Biegependel, vorgesehen ist.

Gemäß der Erfindung umfasst der Isolator zumindest einen pneumatischen Aktor.

Der Isolator ist also für den Einsatz in einem aktiven Schwingungsisolationssystem vorgesehen, bei welchem mittels eines pneumatischen Aktors Kompensationskräfte zur aktiven Reduzierung von Schwingungen erzeugt werden können.

Der Aktor dient dabei vorzugsweise nicht der Entkopplung der schwingungsisoliert gelagerten Last vom Boden, sondern allein dazu, Kompensationskräfte zu erzeugen, um Gegenkräfte zu erzeugen.

Im Unterschied zum eingangs beschriebenen Stand der Technik ist der Aktor zur Erzeugung von Kompensationskräften als pneumatischer Aktor ausgebildet. Es hat sich herausgestellt, dass auch mit einem pneumatischen Aktor hohe Gegenkräfte erzeugt werden können. Gleichzeitig wird gegenüber elektrisch betriebenen Aktoren die Wärmeabfuhr erheblich reduziert.

Bei einer Weiterbildung der Erfindung erstreckt sich der pneumatische Aktor ringförmig um einen Kolben der pneumatischen Feder.

Der Arbeitsraum des pneumatischen Aktors, also das Druckvolumen, durch das über den Kolben des pneumatischen Aktors Kräfte erzeugt werden, erstreckt sich vorzugsweise ebenfalls ringförmig um einen Kolben des Isolators herum, welcher Teil einer pneumatischen Feder ist, die der Entkopplung der schwingungsisoliert gelagerten Last vom Boden dient.

Der pneumatische Aktor ist so integraler Bestandteil des Isolators. So wird eine besonders kompakte Bauweise ermöglicht.

Insbesondere kann der pneumatische Aktor in einem Arbeitsraum der pneumatischen Feder angeordnet sein.

Bei einer bevorzugten Ausführungsform ist ein Kolben des pneumatischen Aktors über zumindest zwei voneinander beabstandete Blattfedern geführt.

Es ist insbesondere vorgesehen, dass zwischen dem Kolben des pneumatischen Aktors und der angrenzenden Wand des Arbeitsraums ein Spalt vorhanden ist, der derart breit ist, dass im Normalbetrieb der Kolben nicht an der angrenzenden Wand des Arbeitsraums anstößt.

So entstehen zwischen Kolben und angrenzender Wand keinerlei Reibkräfte, welche Schwingungen verursachen könnten.

Vorzugsweise ist auch ein Kolben einer pneumatischen Feder des Isolators über die zumindest zwei voneinander beabstandeten Blattfedern axial geführt.

Diese Ausführungsform sieht also vor, dass sowohl der pneumatische Aktor als auch die pneumatische Feder nur in einer Raumrichtung, vorzugsweise nur in vertikaler Richtung, wirksam sind. Für eine axiale Führung des Kolbens sowohl des Isolators als auch des pneumatischen Aktors sind voneinander beabstandete Blattfedern vorgesehen, über die die Kolben jeweils mit der Basis des Isolators, also mit dem bodenseitigen Teil des Isolators, derart gekoppelt sind, dass sich die beiden Kolben nur in axialer Richtung verschieben lassen.

Gemäß der Erfindung ist der pneumatische Aktor in zwei Raumrichtungen wirksam. Hierzu ist insbesondere vorgesehen, dass der Kolben den Arbeitsraum des Aktors in zwei Druckkammern aufteilt.

So kann der Kolben durch Einleiten von Fluid in die jeweilige Druckkammer in zwei entgegengesetzte Richtungen verschoben werden.

Gemäß der Erfindung umfasst der Isolator sowohl einen in horizontaler Richtung wirksamen Aktor als auch einen in vertikaler Richtung wirksamen Aktor.

Beide Aktoren sind vorzugsweise als pneumatische Aktoren ausgebildet. So können Kompensationskräfte sowohl in vertikaler, als auch in horizontaler Richtung erzeugt werden.

Der in vertikaler Richtung wirksame pneumatische Aktor hat vorzugsweise eine Wirkachse, welche im Wesentlichen auf der Wirkachse der Feder, insbesondere der pneumatischen Feder, liegt. So werden bei dem Erzeugen von Kompensationskräften in vertikaler Richtung keine rotatorischen Kräfte in das System eingebracht.

Der pneumatische Aktor umfasst gemäß einer Ausführungsform einen ringförmigen Arbeitsraum, in welchem ein Kolben angeordnet ist.

Der pneumatische Aktor ist so ringförmig ausgebildet, was es zum einen ermöglicht, ein Bauteil des Isolators, wie beispielsweise den Teil einer Feder, durch den Aktor hindurchzuführen.

Zum anderen wird hierdurch auf einfache Weise ermöglicht, dass eine Wirkachse des pneumatischen Aktors im Wesentlichen mit einer Wirkachse einer Feder des Isolators übereinstimmt.

Der pneumatische Aktor umfasst einen Kolben, welcher vorzugsweise durch einen Spalt von der Wand des Arbeitsraums beabstandet ist.

Der Arbeitsraum wird gemäß einer Ausführungsform der Erfindung in zwei Druckkammern unterteilt. So sind zwei durch die Druckkammern definierten Arbeitsräume vorhanden, was es auf einfache Weise ermöglicht, den pneumatischen Aktor in zwei entgegengesetzte Richtungen wirksam auszugestalten.

Der Arbeitsraum bzw. die beiden Druckkammern sind vorzugsweise durch mindestens eine Membran verschlossen.

Die Abdichtung des Arbeitsraums erfolgt mithin nicht durch den im Arbeitsraum laufenden Kolben, sondern durch eine elastische Membran. Dies ermöglicht eine besonders niedrige Steifigkeit in Wirkrichtung, da sich keine Bauteile reibend berühren. Gleichzeitig wird das Erzeugen von Schwingungen aufgrund von gegeneinander gleitender Bauteile vermieden.

Das aktive Schwingungsisolationssystem umfasst in der Regel Sensoren, über die Schwingungen des Bodens und/oder Schwingungen der schwingungsisoliert gelagerten Last erfasst werden. Diese Sensoren sind mit einer Regeleinrichtung verbunden, über die Aktoren angesteuert werden, um Kompensationskräfte zu erzeugen.

Diese Kompensationskräfte können sowohl bodenseitig in das System prolongierenden Schwingungen entgegenwirken, als auch Schwingungen reduzieren, die von Teilen der schwingungsisoliert gelagerten Last erzeugt werden, wie beispielsweise Maschinen mit beweglichen Teilen.

Zur Ansteuerung des oder der pneumatischen Aktoren sind pneumatische Ventile vorgesehen, welche von der Regeleinrichtung angesteuert werden.

Da aufgrund der Kompressibilität eines Pneumatikfluids das Volumen des in den pneumatischen Aktor eingeleiteten Fluids nicht proportional zur erzeugten Kraft ist, ist es bei einer Ausführungsform der Erfindung vorgesehen, dass in eine Regelschleife zur Ansteuerung des pneumatischen Aktors ein Drucksensor eingebunden ist, der den Druck innerhalb eines Arbeitsraums des pneumatischen Aktors, insbesondere innerhalb einer Druckkammer, misst. Über einen derartigen Drucksensor kann auf einfache Weise eine Proportionalität erreicht werden.

Alternativ ist denkbar, einen Kraftsensor zu verwenden, der unmittelbar die vom pneumatischen Aktor ausgeübte Kraft misst.

### Kurzbeschreibung der Zeichnungen

Der Gegenstand der Erfindung soll im Folgenden bezugnehmend auf ein in den Zeichnungen Fig. 1 bis Fig. 12 dargestelltes Ausführungsbeispiel näher erläutert werden.
Fig. 1 ist eine aufgeschnittene Ansicht eines Ausführungsbeispiels eines erfindungsgemäßen Isolators.
Fig. 2 ist eine perspektivische Ansicht des Isolators.
Fig. 3 ist eine perspektivische Darstellung eines für den Isolator verwendeten pneumatischen Aktor.
Fig. 4 ist eine Explosionsdarstellung des in Fig. 3 dargestellten Aktors.
Fig. 5 ist eine Schnittansicht des Aktors.
Fig. 6 ist eine Detailansicht der Fig. 5.
Fig. 7 ist eine perspektivische Ansicht des Aktors, wobei ein Teil des Gehäuses sowie eine Membran, welche den Arbeitsraum verschließt, ausgeblendet sind.
Fig. 8 ist eine Detaildarstellung in Schnittansicht, in welcher der in den Isolator eingebaute Aktor zu erkennen ist.
Fig. 9 ist eine Explosionsdarstellung der im Arbeitsraum des Isolators vorhandenen Bauteile.
Fig. 10 ist eine perspektivische Darstellung der im Arbeitsraum des Isolators angeordneten Bauteile.
Fig. 11 ist eine Explosionsdarstellung eines weiteren Aktors, welcher zur Erzeugung von Kompensationskräften in horizontaler Richtung vorgesehen ist.
Fig. 12 ist eine schematische Darstellung eines Schwingungsisolationssystems.

### Detaillierte Beschreibung der Zeichnungen

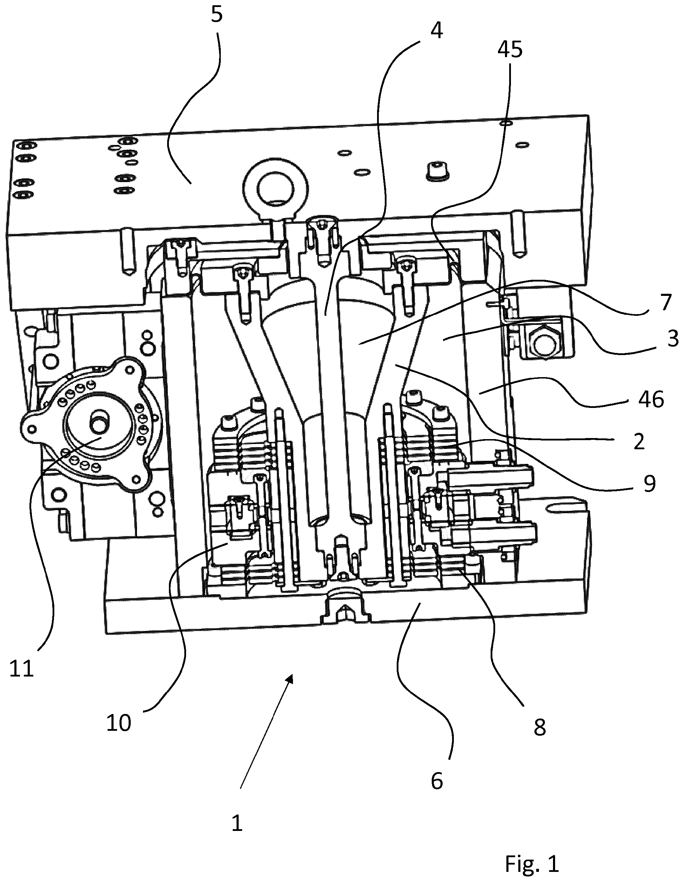

Fig. 1 ist eine aufgeschnittene perspektivische Ansicht eines Ausführungsbeispiels eines erfindungsgemäßen Isolators 1.

Der Isolator 1 umfasst ein Oberteil 5, welches in diesem Ausführungsbeispiel als Platte ausgebildet ist und welches im eingebauten Zustand Teil der zu isolierenden Last ist.

Das Oberteil 5 ist gegenüber der Basis 6, welche im eingebauten Zustand mit dem Boden verbunden ist, schwingungsisoliert gelagert.

In diesem Ausführungsbeispiel umfasst hierzu der Isolator 1 eine pneumatische Feder.

Zu erkennen ist der Arbeitsraum 3 der pneumatischen Feder, in welchen Druckluft einleitbar ist.

Über den Arbeitsraum 3 wird der Kolben 2 abgestützt und so eine Schwingungsisolation in vertikaler Richtung bereitgestellt.

Der Arbeitsraum 3 ist mit einer Membran 45 verschlossen.

Der Kolben 2 ist durch zwei voneinander beabstandete Blattfederpakete 8, 9 axial geführt.

Zur Bereitstellung einer horizontalen Isolationswirkung ist der Kolben 2 über ein Biegependel 4 mit dem Oberteil 5 verbunden.

Um eine kompakte Bauweise bereitzustellen, befindet sich in dieser Ausführungsform das Biegependel 4 in einer Einsenkung 7 des Kolbens 2.

Weiter umfasst der Isolator 1 den pneumatischen Aktor 10, welcher in vertikaler Richtung wirksam ist und über den Kompensationskräfte erzeugt werden können.

Der pneumatische Aktor 10 ist ringförmig ausgebildet und befindet sich im Arbeitsraum 3 der pneumatischen Feder.

Weiter befindet sich der pneumatische Aktor 10 zwischen den beiden Blattfederpaketen 8 und 9.

Zur Erzeugung von Kompensationskräften in horizontaler Richtung ist zumindest ein weiterer pneumatischer Aktor 11 vorgesehen, welcher sich neben dem Gehäuse 46 des Arbeitsraums 3 der pneumatischen Feder befindet.

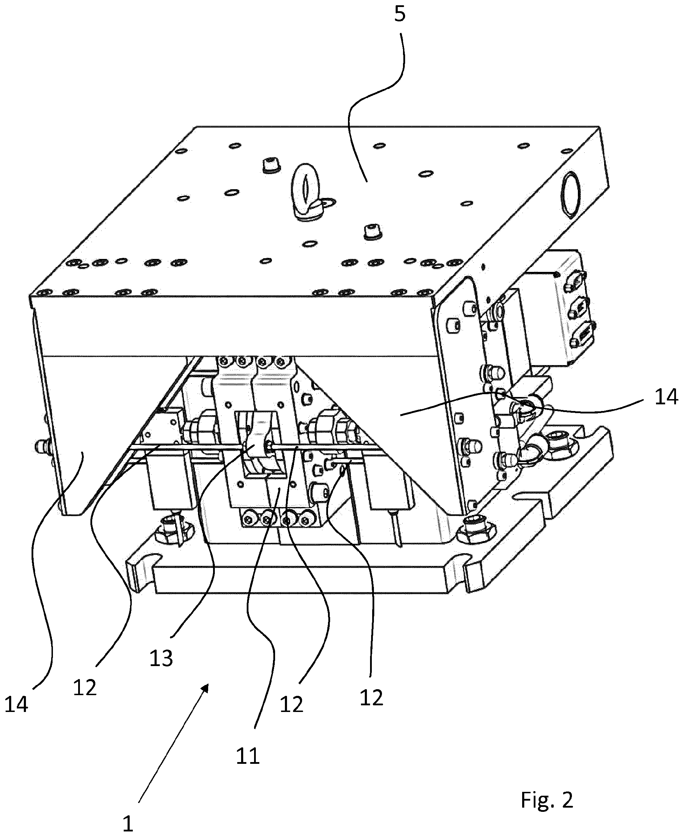

Fig. 2 ist eine perspektivische Darstellung des in Fig. 1 dargestellten Aktors.

Zu erkennen ist hier insbesondere der pneumatische Aktor 11, welcher der Erzeugung von Gegenkräften in horizontaler Richtung dient.

Zu sehen ist, dass aus dem pneumatischen Aktor 11 ein Fortsatz 13 herausschaut. Der Fortsatz 13 ist mit einem Kolben verbunden bzw. Teil eines Kolbens, mittels dessen Gegenkräfte erzeugt werden.

Der Kolben ist über Biegestäbe 12 mit Auslegern 14 des Oberteils 5 verbunden.

Die Biegestäbe 12 dienen einer Entkopplung des Aktors 11 quer zu dessen Wirkrichtung.

Der hier zu sehende Fortsatz 13 schaut seitlich aus dem Gehäuse des pneumatischen Aktors 11 heraus. Weitere Fortsätze sind innerhalb des Gehäuses angeordnet, wobei die Biegestäbe in diesem Fall durch Öffnungen des Gehäuses des pneumatischen Aktors 11 geführt sind.

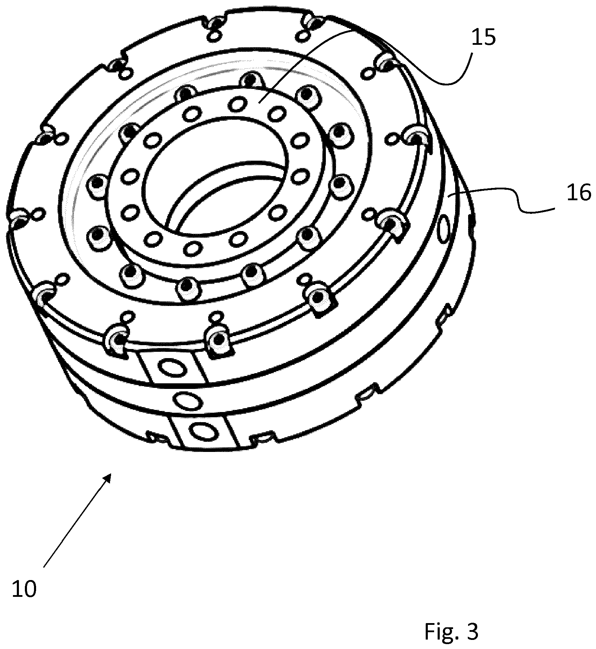

Fig. 3 ist eine perspektivische Ansicht des in Fig. 1 dargestellten pneumatischen Aktors 10.

Der pneumatische Aktor 10 ist ringförmig ausgebildet und besteht aus einem Gehäuse 16, in welchem ein in axialer Richtung beweglicher Kolben 15 angeordnet ist.

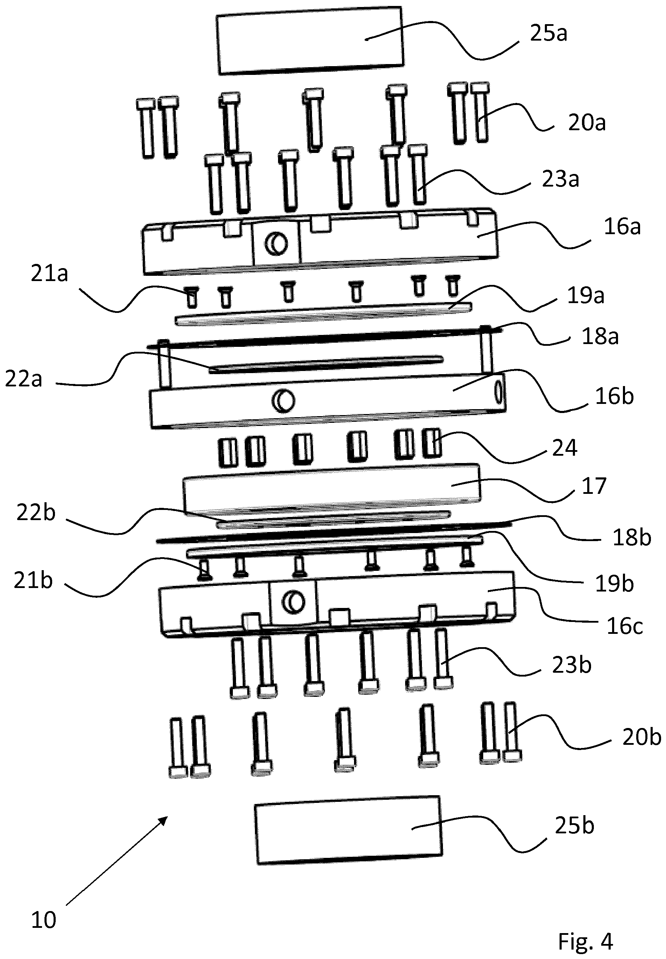

Fig. 4 ist eine Explosionsdarstellung des in Fig. 3 dargestellten pneumatischen Aktors.

Zu sehen ist, dass das Gehäuse aus drei Teilen besteht, nämlich aus dem Gehäuseoberteil 16a, dem Gehäusemittelteil 16b sowie dem Gehäuseunterteil 16c.

Innerhalb des so gebildeten Gehäuses ist ein Kolben angeordnet, welcher in diesem Ausführungsbeispiel aus einem Kolbenmittelteil 17 besteht, an welchem die Fortsätze 25a und 25b angebracht werden.

Die Fortsätze 25a und 25b können mit der zu isolierenden Last verbunden werden, wohingegen das Gehäuse (bestehend aus den Teilen 16a bis 16c) mit der Basis gekoppelt wird.

Der hier dargestellte pneumatische Aktor 10 ist in zwei entgegengesetzten Richtungen wirksam.

Hierzu unterteilt der Kolben bzw. das Kolbenmittelteil 17 den Arbeitsraum in zwei Druckkammern.

Die Druckkammern sind jeweils mit einer Membran 18a, 18b verschlossen, so dass sich in diesem Ausführungsbeispiel die eine Druckkammer zwischen dem Gehäuseoberteil 16a und der Membran 18a und die andere Druckkammer zwischen dem Gehäuseunterteil 16c und der Membran 18b befindet.

Die Membrane 18a, 18b werden mit dem Kolben bzw. Kolbenmittelteil 17 verbunden.

Hierzu ist jeweils ein Spannring 19a, 19b vorgesehen.

Die Spannringe 19a und 19b befinden sich somit jeweils in der Druckkammer.

Die Spannringe 19a und 19b werden mit den Schrauben 21a und 21b am Kolben bzw. am Kolbenmittelteil 17 befestigt und fixieren jeweils eine Membran 18a, 18b. Ein gegenüber den Spannringen 19a und 19b gegenüberliegender Spannring 22a, 22b fixiert die Membran 18a, 18b jeweils am Gehäuse bzw. am Gehäuseoberteil 16a und am Gehäuseunterteil 16c. Gehäuseoberteil 16a und Gehäuseunterteil 16c werden in diesem Ausführungsbeispiel mit den Schrauben 20a und 20b mit dem Gehäusemittelteil 16b verbunden.

Es ist ferner ein weiterer Ring von Schrauben 23a, 23b vorgesehen. Die Schrauben 23a und 23b werden in die Gewindehülsen 24 geschraubt und verbinden so Gehäuseoberteil 16a und Gehäuseunterteil 16c.

Die Gewindehülsen 24 sind durch Bohrungen des Kolbens bzw. des Kolbenmittelteils 17 geführt, die derart groß sind, dass die Gewindehülsen 24 im Kolben so viel Spiel haben, dass diese nicht an den Bohrungen des Kolbens anliegen.

Die über die Schrauben 23a und 23b sowie die Gewindehülsen 24 geschaffene weitere Verbindung dient einer optimalen Flächenpressung der Gehäusebauteile. Es versteht sich, dass hierauf auch verzichtet werden könnte.

Die Membran 18a und 18b dient jeweils gleichzeitig der Abdichtung des Gehäuseoberteils 16a und des Gehäuseunterteils 16c gegenüber dem Gehäusemittelteil 16b.

Es versteht sich, dass der pneumatische Aktor 10 des Weiteren auch noch Fluidzuführungen aufweist, um Druckluft den Arbeitsräumen zuzuführen.

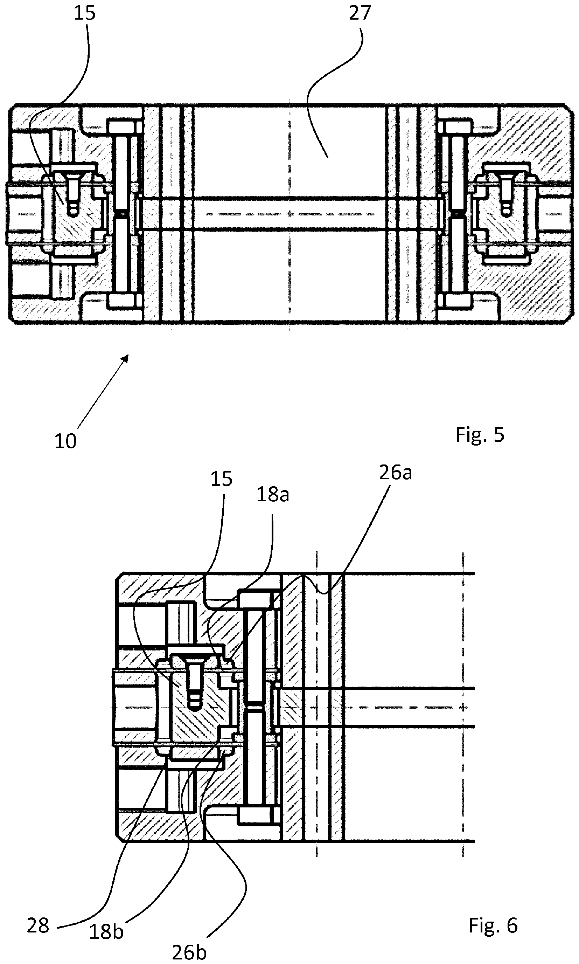

Fig. 5 ist eine Schnittansicht des zuvor dargestellten pneumatischen Aktors 10.

Zu erkennen ist der ringförmig ausgestaltete Kolben 15.

Weiter ist zu erkennen, dass der pneumatische Aktor 10 einen mittigen Durchgang 27 aufweist, durch den beispielsweise Bauteile des Isolators hindurchgeführt werden können.

Fig. 6 ist eine Detailansicht der Fig. 5.

Zu erkennen ist, dass der Kolben 15 über einen Spalt 28 von der angrenzenden Gehäusewand beabstandet ist.

Die Druckkammern 26a und 26b sind mittels einer Membran 18a, 18b verschlossen.

Zu erkennen ist ferner, dass der durch die Druckkammern 26a, 26b gebildete Arbeitsraum recht klein ist. Bei dem pneumatischen Aktor reicht ein sehr kleiner Arbeitsraum, insbesondere ein Arbeitsraum unter 10 cm³, vorzugsweise unter 5 cm³, da der Aktor nicht als pneumatische Feder, sondern nur zur Erzeugung von Gegenkräften dient.

Im Falle der Verwendung einer pneumatischen Feder als Isolationselement beträgt das Volumen des Arbeitsraums des pneumatischen Aktors (Summe der Volumina der Druckkammern) vorzugsweise höchstens 1/5, besonders bevorzugt höchstens 1/10, des Volumens des Arbeitsraums der pneumatischen Feder.

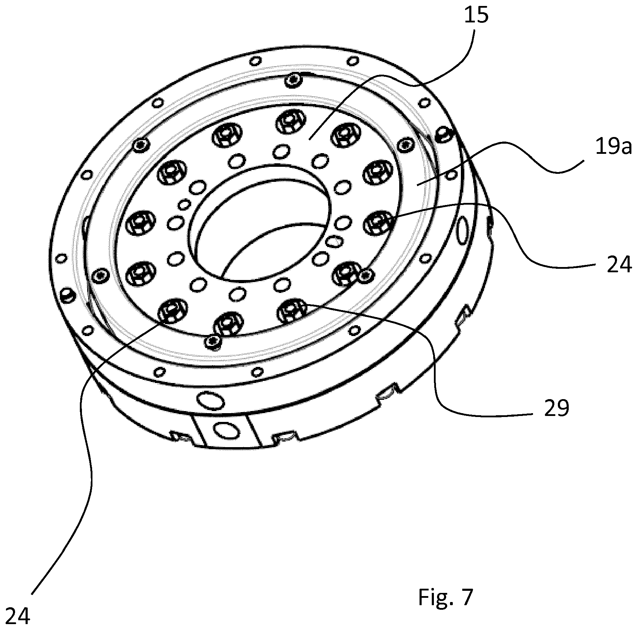

Fig. 7 ist eine perspektivische Ansicht des pneumatischen Aktors, wobei das Gehäuseoberteil und die Membran, mit welcher der obere Arbeitsraum verschlossen ist, ausgeblendet sind.

Zu erkennen ist in dieser Ansicht der Spannring 19a, mit dem die Membran (ausgeblendet) am Kolben 15 befestigt wird.

Weiter zu erkennen sind die Gewindehülsen 24, über die Gehäuseoberteil und Gehäuseunterteil verbunden werden und welche mit Spiel in Bohrungen 29 des Kolbens 15 angeordnet sind.

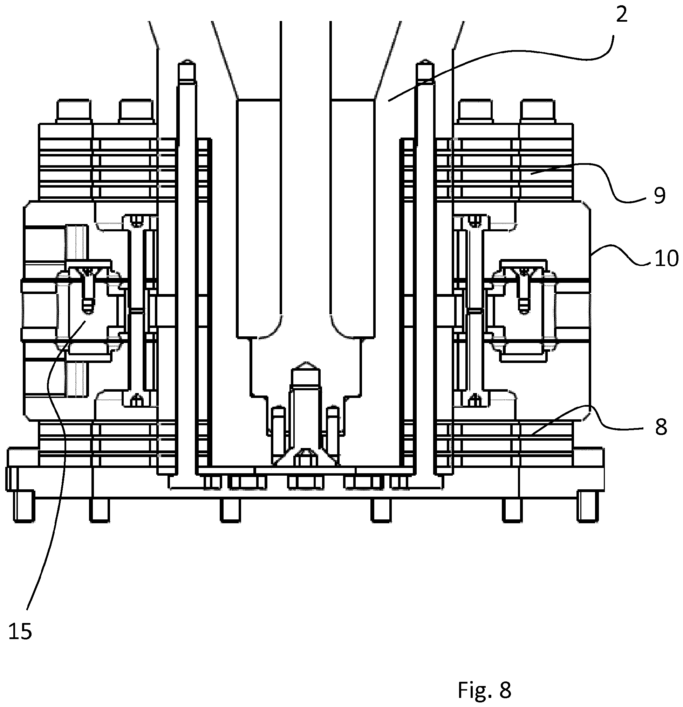

Fig. 8 ist eine weitere Schnittansicht des Isolators.

Zu erkennen ist der ringförmig ausgebildete Kolben 15 des pneumatischen Aktors 10, welcher sich um den Kolben 2 der pneumatischen Feder des Isolators erstreckt.

Der Kolben 15 ist mit dem Kolben 2 verbunden.

Die Wirkachse der pneumatischen Feder mit dem Kolben 2 sowie die Wirkachse des pneumatischen Aktors 10 liegen so aufeinander.

Weiter zu erkennen sind die voneinander beabstandeten Blattfederpakete 8 und 9, zwischen denen der pneumatische Aktor 10 angeordnet ist.

Da der Kolben 15 mit dem Kolben 2 starr verbunden ist, wird durch die voneinander beabstandeten Blattfedern der Blattfederpakete 8 und 9 sowohl der Kolben 2 als auch der Kolben 15 des pneumatischen Aktors axial geführt.

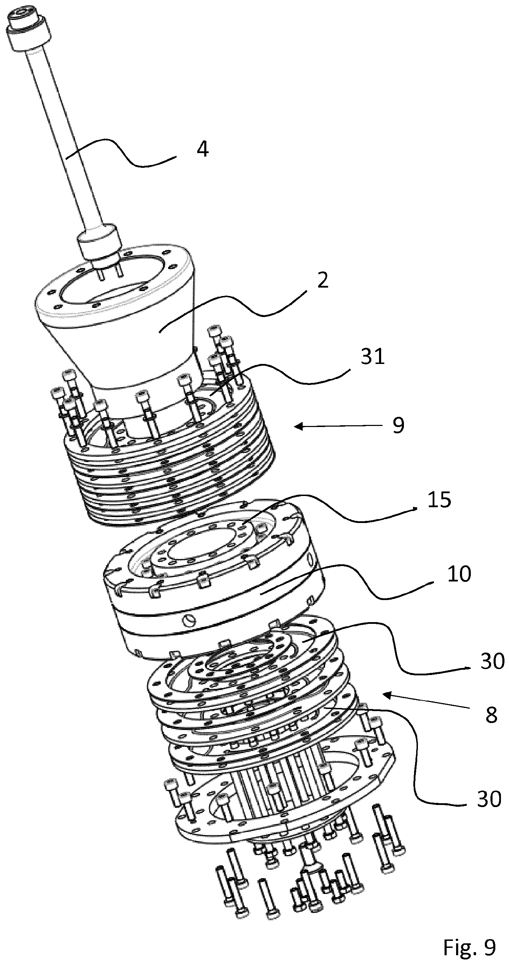

Fig. 9 ist eine perspektivische Explosionsdarstellung der Bauteile, welche im montierten Zustand im Arbeitsraum der pneumatischen Feder angeordnet sind.

Zu erkennen ist der Biegestab 4, der mit dem Kolben 2 verbunden wird.

Weiter zu erkennen ist, dass sowohl die Blattfedern 31 des oberen Blattfederpakets 9 als auch die Blattfedern 30 des unteren Blattfederpakets 8 aus Ringsegmenten bestehen.

Zwischen den Blattfederpaketen 8 und 9 kann auf einfache Weise der pneumatische Aktor 10 montiert werden.

Der Kolben 15 wird sowohl mit dem Kolben 2 als auch mit den Blattfederpaketen 8 und 9 verbunden.

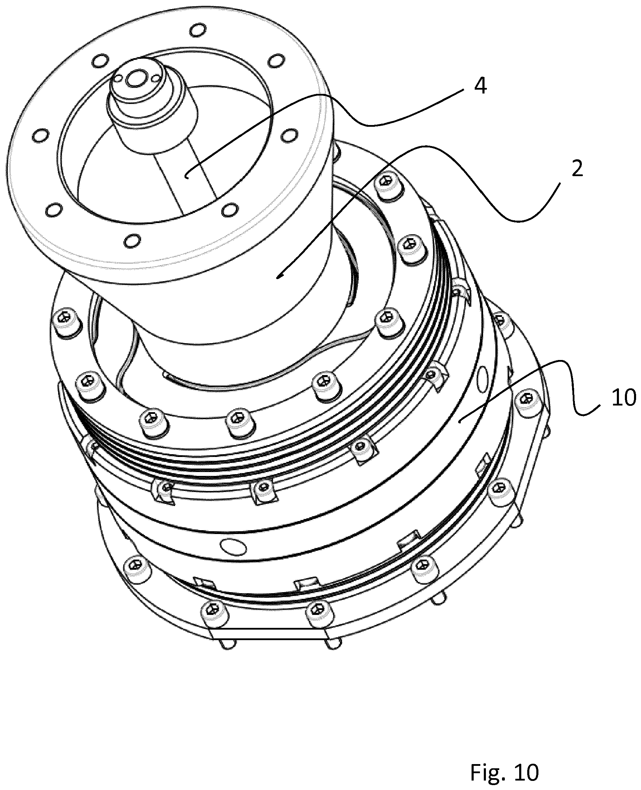

Fig. 10 zeigt die in Fig. 9 dargestellten Bauteile im montierten Zustand.

Zu erkennen ist, dass der pneumatische Aktor 10 integraler Bestandteil eines den Kolben 2 umfassenden Innenteils der pneumatischen Feder ist, aus welchem das Biegependel 4 herausschaut, welches mit der zu isolierenden Last gekoppelt wird.

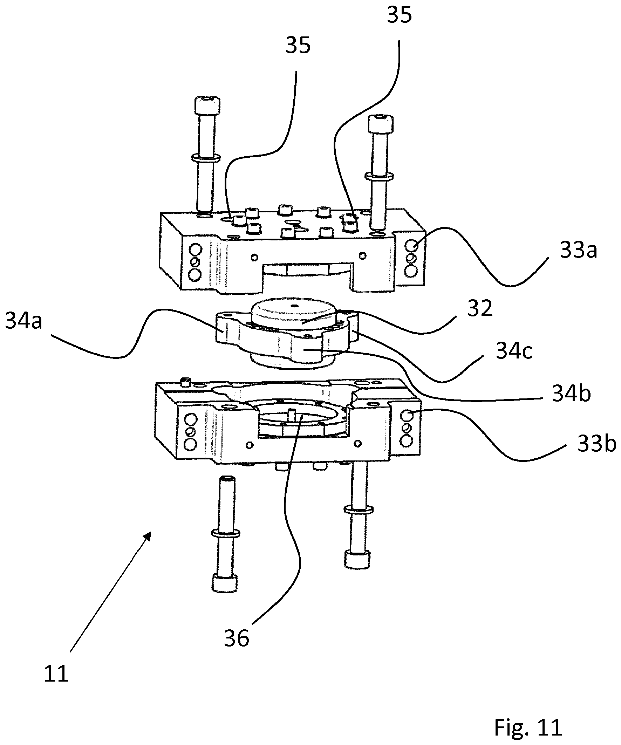

Fig. 11 ist eine Explosionsdarstellung des in Fig. 1 gezeigten weiteren pneumatischen Aktors 11, welcher der Erzeugung von horizontalen Kompensationskräften dient.

Zu sehen ist, dass der pneumatische Aktor 11 ein Gehäuse mit einem Gehäuseoberteil 33a und einem Gehäuseunterteil 33b umfasst, in welches im montierten Zustand der Kolben 32 eingesetzt ist, der den Arbeitsraum in zwei Hälften aufteilt.

Zu erkennen ist hier eine Membran 36, die eine Druckkammer verschließt und die mit dem Kolben 32 verbunden wird.

Das Gehäuseoberteil 33a ist entsprechend ausgebildet und umfasst ebenfalls eine mit einer Membran verschlossene Druckkammer, so dass auch der Aktor 11 in zwei entgegengesetzten Richtungen wirksam ist.

Weiter ist zu erkennen, dass der Kolben 32 drei Fortsätze 34a - 34c aufweist, an denen Biegestäbe angebracht werden können (12 in Fig. 2), über die der pneumatische Aktor 11 mit der zu isolierenden Last verbunden wird.

Der Fortsatz 34b ist aus dem Gehäuse herausgeführt.

Die an den Fortsätzen 34a und 34c anzubringenden Biegestäbe werden im montierten Zustand durch die Bohrungen 35 des Gehäuses geführt.

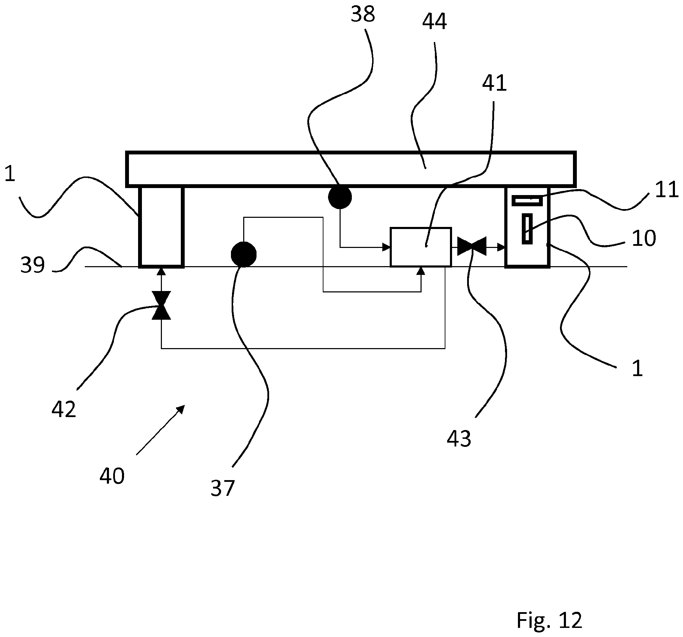

Fig. 12 ist eine schematische Darstellung eines Schwingungsisolationssystems 40, in welchem die zuvor beschriebenen Isolatoren 1 verbaut sind.

Das Schwingungsisolationssystem 40 umfasst eine Platte 44, die auf mehreren Isolatoren 1 schwingungsisoliert auf dem Boden 39 gelagert ist.

In diesem Ausführungsbeispiel ist sowohl ein Sensor 37 vorgesehen, welcher Schwingungen des Bodens erfasst, als auch ein Sensor 38, welcher Schwingungen der zu isolierenden Last erfasst.

Signale dieser Sensoren werden an die Regeleinrichtung 41 weitergegeben, die ihrerseits pneumatische Ventile 42, 43 zur Ansteuerung der in den Isolatoren 1 integrierten pneumatischen Aktoren 10, 11 steuert.

Über die pneumatischen Aktoren 10, 11 werden, basierend auf den Sensorsignalen, Kompensationskräfte sowohl in horizontaler als auch in vertikaler Richtung erzeugt.

Es ist hier jeweils nur ein Regelventil dargestellt.

Es versteht sich, dass pro pneumatischem Aktor 1 jeweils Regelventile für beide Druckkammern vorhanden sein müssen.

Durch die Erfindung konnte ein Isolator bereitgestellt werden, welcher in einem aktiven Schwingungsisolationssystem hohe Kompensationskräfte bei gleichzeitig geringer Wärmeabfuhr erzeugt.

### Bezugszeichenliste

- 1: Isolator
- 2: Kolben
- 3: Arbeitsraum
- 4: Biegependel
- 5: Oberteil
- 6: Basis
- 7: Einsenkung
- 8: Blattfederpaket
- 9: Blattfederpaket
- 10: Aktor
- 11: Aktor
- 12: Biegestab
- 13: Fortsatz
- 14: Ausleger
- 15: Kolben
- 16: Gehäuse
- 16a: Gehäuseoberteil
- 16b: Gehäusemittelteil
- 16c: Gehäuseunterteil
- 17: Kolbenmittelteil
- 18a, 18b: Membran
- 19a, 19b: Spannring
- 20a, 20b: Schrauben
- 21a, 21b: Schrauben
- 22a, 22b: Spannring
- 23a, 23b: Schrauben
- 24: Gewindehülsen
- 25a, 25b: Fortsatz
- 26a, 26b: Druckkammer
- 27: Durchgang
- 28: Spalt
- 29: Bohrung
- 30: Blattfeder
- 31: Blattfeder
- 32: Kolben
- 33a: Gehäuseoberteil
- 33b: Gehäuseunterteil
- 34a-34c: Fortsatz
- 35: Bohrung
- 36: Membran
- 37: Sensor
- 38: Sensor
- 39: Boden
- 40: Schwingungsisolationssystem
- 41: Regeleinrichtung
- 42: Ventil
- 43: Ventil
- 44: Platte
- 45: Membran
- 46: Gehäuse

## Patentansprüche

1. Aktives stationäres Schwingungsisolationssystem (40), umfassend zumindest einen Isolator (1), welcher in horizontaler und vertikaler Richtung wirksam ist, wobei der Isolator (1) einen in horizontaler Richtung wirksamen pneumatischen Aktor (11) und einen in vertikaler Richtung wirksamen pneumatischen Aktor (10) umfasst, wobei die pneumatischen Aktoren (10, 11) in zwei Raumrichtungen wirksam sind, und wobei mittels der pneumatischen Aktoren (10, 11) Kompensationskräfte sowohl in vertikaler, als auch in horizontaler Richtung zur aktiven Reduzierung von Schwingungen erzeugbar sind, **dadurch gekennzeichnet, dass** der Isolator ferner eine pneumatische Feder umfasst, die zumindest in vertikaler Richtung wirksam ist.

2. Aktives stationäres Schwingungsisolationssystem (40)nach dem vorstehenden Anspruch, **dadurch gekennzeichnet, dass** sich der in vertikaler Richtung wirksame pneumatische Aktor (10) ringförmig um einen Kolben (2) der pneumatischen Feder erstreckt.

3. Aktives stationäres Schwingungsisolationssystem (40)nach einem der vorstehenden Ansprüche, **dadurch gekennzeichnet, dass** der in vertikaler Richtung wirksame pneumatische Aktor (10) in einem Arbeitsraum (3) der pneumatischen Feder angeordnet ist.

4. Aktives stationäres Schwingungsisolationssystem (40)nach einem der vorstehenden Ansprüche, **dadurch gekennzeichnet, dass** ein Kolben (15) des in vertikaler Richtung wirksamen pneumatischen Aktors (10) über zumindest zwei voneinander beabstandete Blattfedern axial geführt ist.

5. Aktives stationäres Schwingungsisolationssystem (40)nach dem vorstehenden Anspruch, **dadurch gekennzeichnet, dass** auch ein Kolben (2) der pneumatischen Feder über die zumindest zwei voneinander beabstandeten Blattfedern axial geführt ist.

6. Aktives stationäres Schwingungsisolationssystem (40) nach einem der vorstehenden Ansprüche, wobei der pneumatische Aktor (10), einen ringförmigen Arbeitsraum umfasst, in welchem ein Kolben (15) angeordnet ist.

7. Aktives stationäres Schwingungsisolationssystem (40) nach dem vorstehenden Anspruch, **dadurch gekennzeichnet, dass** der Kolben (15) durch einen Spalt (28) von der Wand des Arbeitsraums beabstandet ist.

8. Aktives stationäres Schwingungsisolationssystem (40) nach Anspruch 6 oder 7, **dadurch gekennzeichnet, dass** der Kolben (15) den Arbeitsraum in zwei Druckkammern 26a, 26b unterteilt.

9. Aktives stationäres Schwingungsisolationssystem (40) nach Anspruch 7 oder 8, **dadurch gekennzeichnet, dass** der Arbeitsraum durch mindestens eine Membran (18a, 18b) verschlossen ist.

10. Aktives stationäres Schwingungsisolationssystem (40) nach einem der vorstehenden Ansprüche, umfassend zur Ansteuerung des pneumatischen Aktors (10) eine Regelschleife, in die ein Drucksensor, der den Druck innerhalb eines Arbeitsraums des pneumatischen Aktors misst oder ein Kraftsensor, der die vom pneumatischen Aktor ausgeübte Kraft misst, eingebunden ist.

## Claims

1. An active stationary vibration isolation system (40), comprising at least one isolator (1) that is effective in the horizontal and vertical directions, said isolator (1) comprising a pneumatic actuator (11) effective in the horizontal direction and a pneumatic actuator (10) effective in the vertical direction;
wherein the pneumatic actuators (10, 11) are effective in two spatial directions, and wherein the pneumatic actuators (10, 11) are able to produce compensation forces in both the vertical and horizontal directions for actively reducing vibrations;
**characterized in that** the isolator furthermore comprises a pneumatic spring which is effective at least in the vertical direction.

2. The active stationary vibration isolation system (40) according to the preceding claim, **characterized in that** the pneumatic actuator (10) effective in the vertical direction extends annularly around a piston (2) of the pneumatic spring.

3. The active stationary vibration isolation system (40) according to any one of the preceding claims, **characterized in that** the pneumatic actuator (10) effective in the vertical direction is arranged within a working space (3) of the pneumatic spring.

4. The active stationary vibration isolation system (40) according to any one of the preceding claims, **characterized in that** a piston (15) of the vertically effective pneumatic actuator (10) is guided axially by at least two spaced-apart leaf springs.

5. The active stationary vibration isolation system (40) according to the preceding claim, **characterized in that** a piston (2) of the pneumatic spring is also guided axially by the at least two spaced-apart leaf springs.

6. The active stationary vibration isolation system (40) according to any one of the preceding claims, wherein the pneumatic actuator (10) comprises an annular working space with a piston (15) arranged therein.

7. The active stationary vibration isolation system (40) according to the preceding claim, **characterized in that** the piston (15) is spaced apart from the wall of the working space by a gap (28).

8. The active stationary vibration isolation system (40) according to claim 6 or 7, **characterized in that** the piston (15) divides the working space into two pressure chambers (26a, 26b) .

9. The active stationary vibration isolation system (40) according to claim 7 or 8, **characterized in that** the working space is sealed by at least one diaphragm (18a, 18b).

10. The active stationary vibration isolation system (40) according to any one of the preceding claims, comprising a control loop for controlling the pneumatic actuator (10), and integrated into it a pressure sensor which measures the pressure within a working space of the pneumatic actuator, or a force sensor which measures the force exerted by the pneumatic actuator.

## Revendications

1. Système actif fixe d'isolation des vibrations (40), comprenant au moins un isolateur (1), lequel agit dans les directions horizontale et verticale, dans lequel l'isolateur (1) comprend un actionneur pneumatique (11) agissant dans la direction horizontale et un actionneur pneumatique (10) agissant dans la direction verticale,
dans lequel les actionneurs pneumatiques (10, 11) agissent dans deux directions spatiales, et dans lequel des forces de compensation peuvent être produites aussi bien dans la direction verticale que dans la direction horizontale au moyen des actionneurs pneumatiques (10, 11) pour réduire activement les vibrations, **caractérisé en ce que** l'isolateur comprend en outre un ressort pneumatique qui agit au moins dans la direction verticale.

2. Système actif fixe d'isolation des vibrations (40) selon la revendication précédente, **caractérisé en ce que** l'actionneur pneumatique (10) agissant dans la direction verticale s'étend de manière annulaire autour d'un piston (2) du ressort pneumatique.

3. Système actif fixe d'isolation des vibrations (40) selon l'une quelconque des revendications précédentes, **caractérisé en ce que** l'actionneur pneumatique (10) agissant dans la direction verticale est agencé dans une chambre de travail (3) du ressort pneumatique.

4. Système actif fixe d'isolation des vibrations (40) selon l'une quelconque des revendications précédentes, **caractérisé en ce qu'**un piston (15) de l'actionneur pneumatique (10) agissant dans la direction verticale est guidé axialement par l'intermédiaire d'au moins deux ressorts à lames espacés l'un de l'autre.

5. Système actif fixe d'isolation des vibrations (40) selon la revendication précédente, **caractérisé en ce qu'**un piston (2) du ressort pneumatique est lui aussi guidé axialement par l'intermédiaire des au moins deux ressorts à lames espacés l'un de l'autre.

6. Système actif fixe d'isolation des vibrations (40) selon l'une quelconque des revendications précédentes, dans lequel l'actionneur pneumatique (10) comprend une chambre de travail annulaire dans laquelle est agencé un piston (15).

7. Système actif fixe d'isolation des vibrations (40) selon la revendication précédente, **caractérisé en ce que** le piston (15) est espacé de la paroi de la chambre de travail par une fente (28).

8. Système actif fixe d'isolation des vibrations (40) selon la revendication 6 ou 7, **caractérisé en ce que** le piston (15) divise la chambre de travail en deux chambres de pression (26a, 26b).

9. Système actif fixe d'isolation des vibrations (40) selon la revendication 7 ou 8, **caractérisé en ce que** la chambre de travail est fermée par au moins une membrane (18a, 18b).

10. Système actif fixe d'isolation des vibrations (40) selon l'une quelconque des revendications précédentes, comprenant, pour la commande de l'actionneur pneumatique (10), une boucle d'asservissement dans laquelle est inséré un capteur de pression, qui mesure la pression à l'intérieur d'une chambre de travail de l'actionneur pneumatique, ou un capteur de force, qui mesure la pression exercée par l'actionneur pneumatique.
